(19) Europäisches Patentamt
European Patent Office
Office européen des brevets

(11) **EP 2 161 840 A2**

(12) **EUROPEAN PATENT APPLICATION**

(43) Date of publication:
**10.03.2010 Bulletin 2010/10**

(51) Int Cl.:
**H03M 13/47** *(2006.01)*     **H03M 13/11** *(2006.01)*

(21) Application number: **09168900.0**

(22) Date of filing: **28.08.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **03.09.2008 GB 0816051**

(71) Applicant: **Newtec Cy N.V.**
**9100 Sint-Niklaas (BE)**

(72) Inventors:
• **Tousch, Jacky Richard**
  **29217 Le Conquet (FR)**
• **Verfaillie, Guido Alois Marcel**
  **9160 Lokeren (BE)**

(74) Representative: **Bird, Ariane et al**
**Bird Goën & Co.**
**Klein Dalenstraat 42A**
**3020 Winksele (BE)**

(54) **Estimating transmission signal quality**

(57)     The invention relates to a method, adapted for a transmission system comprising an error correction code, comprising the steps of evaluating a code syndrome vector for a plurality of decision bits in an error correction decoder, computing the Hamming weight of the code syndrome vector, and estimating the quality of the error correction decoder input signal based on the computed Hamming weight. In this way, an accurate, fast and reliable possibility for estimating transmission signal quality in digital communication systems is provided.

FIG. 3

EP 2 161 840 A2

**Description**

FIELD OF THE INVENTION

The invention relates to the field of telecommunications systems and methods, especially to transmission signal quality estimators in digital communication systems, in particular to systems using an error correction code, such as a low density parity check (LDPC) code, comprising code syndrome vectors and iterative decoding.

BACKGROUND OF THE INVENTION

In digital communication systems, the transmitted signal is corrupted by noise and various other impairments, such as amplifier non-linearities, frequency and/or phase variations. The accurate knowledge of the power ratio between the signal and channel impairments at the receiver is of important value for the receiver designer and the system operator. It allows, among others, e.g. to optimize the receiver algorithms with the knowledge of the signal-to-noise ratio (SNR) or the signal-to-noise-plus-interference ratio (SNIR), or to put in more general terms, the signal-to-noise-plus-distortion ratio (SNDR) allows demodulation and decoding algorithms to implement ideal signal processing algorithms.

The SNR is defined as the ratio of the signal power to the noise power. Both signal and noise power (alternatively: signal and noise amplitude) must be measured at the same or equivalent points in a system and within the same system bandwidth. SNIR, on the other hand, is defined as the signal power over the noise power plus interference power. Finally, SNDR is defined as the ratio between the powers of the signal and the sum of the noise and the generated harmonic spurs responsible for signal distortion. More generally, the term SNDR corresponds to the decoder input signal quality and as such comprises all impairments affecting the signal up to the decoder input, i.e. signal distortion is merely one aspect comprised by SNDR. It is noted that the term "distortion" is encompassing all sources of signal impairments with the sole exclusion of additive white Gaussian noise (AWGN) at the input of a forward error correction (FEC) decoder in the receiver. In the following, distortions comprise amplifier non-linearities, demodulator imperfectness, residual phase or frequency errors, timing errors and gain control errors.

Further, the knowledge of the power ratio between the signal and channel impairments allows to have an estimate of the link margin and thus to be able to optimize the transmission parameters, such as code rate and modulation order, according to the channel conditions. Such an adaptive system is referred to as an adaptive coding and modulation (ACM) system. ACM control can be performed either manually or automatically.

There are many SNR estimation algorithms present. These algorithms can be divided in two classes: algorithms using an a-priori knowledge of the transmitted symbols (so-called pilot symbols), also known as data-aided (DA) algorithms, and algorithms which do not use pilot symbols, also known as non-data-aided (NDA) algorithms. Amongst the NDA algorithms, an algorithm is further a decision-directed (DD) algorithm if it uses a detection or a decoding scheme in order to deliver a provisional (or tentative) symbol value that is used as a-priori information.

Generally speaking, DA algorithms provide reasonable performances but, however, the use of pilot symbols degrades the usable system capacity. NDA algorithms make use of modulated symbols comprising payload information. In case of unknown symbols, NDA algorithms show worse performances than DA algorithms. DD-NDA algorithms can be used to increase the estimator accuracy by using provisional (or tentative) decisions on symbols. However, any decoder error reduces the estimator accuracy.

In "A comparison of SNR Estimation Techniques for the AWGN Channel", by D. Pauluzzi and N. Beaulieu, published in IEEE Transactions on Communications, Oct. 2000, several SNR estimators have been considered and analyzed. In "Channel Quality Estimation techniques for adaptive physical layer satellite systems", published as ESA contribution to Digital Video Broadcasting, European Space Agency, March 2003, two SNIR estimators have been analyzed and characterized in the context of a satellite transmission compliant with DVB-S2 specifications (see ETSI EN 302 307 v1.1.1, 20054-01).

In "A novel variance estimator for turbo-code decoding", by M.C. Reed and J. Asenstorfer, published in Proc. Int. Conf. Telecommun., Apr. 1997, a DD-NDA signal-to-noise estimator using decisions from a turbo decoder is proposed. In "Iterative per-Frame Gain and SNR Estimation for DVB-S2 receivers", by Alan Barbieri, Aldo Cero and Giulio Colavolpe, a factor-graph approach to encompass the SNR estimate along with code and phase variables is proposed.

Prior art algorithms, being either DA or NDA, are provided to perform power estimation on a collection of received complex baseband samples using explicit averaging, possibly using known (e.g. DA) or provisional (tentative) knowledge (e.g. DD-NDA) on individual symbols before averaging. These techniques show the following drawbacks which result in different problems: beyond hard decision on bits they do not make use of any information from the channel decoder; they require the use of pilot symbols (e.g. in a DA algorithm); they are sensitive to decoding errors (e.g. in a DD-NDA algorithm); and they are focused on the measure of signal and noise power and ignore some other transmission defects such as non-linearities and demodulator imperfectness.

## SUMMARY OF THE INVENTION

It is the object of the invention to provide a better possibility for estimating transmission signal quality. Advantages of the present invention can be that it is accurate, fast and reliable.

This object is achieved by a system and method, adapted for a transmission system comprising an error correction code, comprising a) evaluating a code syndrome vector for a plurality of decision bits in an error correction decoder; b) computing the Hamming weight of the code syndrome vector; and c) estimating the quality of the error correction decoder input signal based on the computed Hamming weight.

In general, the Hamming weight corresponds to the Hamming distance from the all-zeroes vector. The Hamming weight in a Galois field with two elements and with a size equal to one, i.e. the Hamming weight in GF (2), corresponds to the number of non-zero elements.

Accordingly, it is an important idea of the invention to provide a system and method for estimating signal quality during a digital transmission using a forward error correction (FEC) scheme. Thus, an SNDR estimator is comprised by an iterative FEC decoder, such as an LDPC decoder, and the Hamming weight of a code syndrome vector is computed, preferably in an iterative decoding process. Hence, the error correction decoder is adapted for performing an iterative process corresponding to performing step b) for a plurality of code syndrome vectors each being evaluated in step a).

According to a preferred embodiment of the invention, an LDPC code is applied. However, also other codes may be applied, since the invention is applicable to any code that considers the code parity check matrix and the associated syndrome computation.

Further, according to another preferred embodiment of the invention, step c) is performed by using the sum of the plurality of Hamming weights computed in step b) for the plurality of code syndrome vectors. Most preferably, the error correction code comprises an LDPC code. Preferably, the iterative process corresponds to one of a flooding-scheduled sum-product algorithm and a shuffled-scheduled sum-product algorithm.

According to yet another preferred embodiment of the invention, the signal quality estimation in step c) is adapted for stopping the iterative process after a predetermined number of iterations. Preferably, the predetermined number of iterations is fixed by comparing the computed Hamming weight of a code syndrome vector with a predetermined value. Alternatively, the predetermined number of iterations is fixed based on an SNDR estimate.

Furthermore, according to another preferred embodiment of the invention, the method further comprises the steps: computing the SNR; and combining the computed SNR with the error correction decoder input signal quality estimation of step c). In this way, a refined signal quality estimation is obtained. Thus, it is also an important idea of the invention to provide a link margin estimator that combines a signal-to-noise estimate and a signal-to-noise-plus-distortion estimate.

According to yet another preferred embodiment of the invention, the error correction decoder input signal quality estimation is translated into an estimation of a transmission link noise margin. Preferably, the transmission link noise margin estimation is adapted for an adaptive coding and modulation system (ACM system) for optimizing transmission parameters with regard to propagation conditions, such as the bit error rate (BER), of the transmission system.

Preferably, the transmission parameters comprise code rate and modulation order and the propagation conditions comprise the bit error rate.

The present invention also provides a system and a decoder unit and a computer software product.

Accordingly, the present invention provides a transmission system for use with an error correction code, comprising:

> a) means for evaluating a code syndrome vector for a plurality of decision bits in an error correction decoder;
> b) means for computing the Hamming weight of the code syndrome vector; and
> c) means for estimating the quality of the error correction decoder input signal based on the computed Hamming weight.

The means for estimating can be adapted to use the sum of the plurality of Hamming weights provided by the means for computing for the plurality of code syndrome vectors.

Preferably the error correction decoder uses an error correction code comprising a low density parity check code.

The error correction decoder can be adapted for performing an iterative process, the iterative process corresponding to one of a flooding-scheduled sum-product algorithm and a shuffled-scheduled sum-product algorithm. In one embodiment, the means for estimating signal quality is adapted for stopping the iterative process after a predetermined number of iterations. For example, the predetermined number of iterations can be fixed by comparing the computed Hamming weight of a code syndrome vector with a predetermined value and/or by evaluating an SNDR estimate.

The system may also comprise:

> d) means for computing the signal-to-noise ratio; and
> e) means for combining the computed signal-to-noise ratio with an error correction decoder input signal quality estimation from the means for estimating the quality of the error correction decoder input signal.

Preferably, the means for estimating the quality of the error correction decoder input signal is adapted to translate the estimated quality into an estimation of a transmission link noise margin. This means for estimating the quality of the error correction decoder input signal can be arranged to adapt the transmission link noise margin estimation for an adaptive coding and modulation system for optimizing transmission parameters with regard to propagation conditions of the transmission system. These transmission parameters can comprise, for example, code rate and modulation order and the propagation conditions comprise the bit error rate.

The present invention also provides a decoder unit for use with an error correction code, comprising:

> a) means for evaluating a code syndrome vector for a plurality of decision bits in an error correction decoder;
> b) means for computing the Hamming weight of the code syndrome vector; and
> c) means for estimating the quality of the error correction decoder input signal based on the computed Hamming weight.

The means for estimating can be adapted to use the sum of the plurality of Hamming weights provided by the means for computing for the plurality of code syndrome vectors.

Preferably, the error correction decoder uses an error correction code comprising a low density parity check code.

Advantageously, the error correction decoder is adapted for performing an iterative process, the iterative process corresponding to one of a flooding-scheduled sum-product algorithm and a shuffled-scheduled sum-product algorithm. Optionally, the means for estimating signal quality can be adapted for stopping the iterative process after a predetermined number of iterations. For example, the predetermined number of iterations is fixed by comparing the computed Hamming weight of a code syndrome vector with a predetermined value and/or by evaluating an SNDR estimate.

The decoder unit can also comprise:

> d) means for computing the signal-to-noise ratio; and
> e) means for combining the computed signal-to-noise ratio with an error correction decoder input signal quality estimation from the means for estimating the quality of the error correction decoder input signal.

Optionally, the means for estimating the quality of the error correction decoder input signal can be adapted to translate the estimated quality into an estimation of a transmission link noise margin. This means for estimating the quality of the error correction decoder input signal can be arranged to adapt the transmission link noise margin estimation for an adaptive coding and modulation system for optimizing transmission parameters with regard to propagation conditions of the transmission system. These transmission parameters can comprise code rate and modulation order and the propagation conditions comprise the bit error rate.

The present invention also includes a computer program product comprising code segments that when executed on a suitable processing engine implement a method adapted for a transmission system for use with an error correction code, the code segments implementing when executed:

> a) evaluation of a code syndrome vector for a plurality of decision bits in an error correction decoder;
> b) computing of the Hamming weight of the code syndrome vector; and
> c) estimating of the quality of the error correction decoder input signal based on the computed Hamming weight. The present invention also includes, a machine readable signal storage medium storing the computer program product. The medium can include a disk storage medium such as a diskette, a hard disk, or solid state memory such as a RAM or a USB memory stick, tape storage, optical disk stoarge such as CD-ROM, DVD etc.

Finally, it is worth noting that the invention provides an accurate, fast and reliable possibility for estimating transmission signal quality and thus helps to overcome the problems of the prior art. Preferred embodiments are described in the sub claims.

BRIEF DESCRIPTION OF THE DRAWINGS

These and other aspects of the invention will be apparent from and elucidated with reference to the embodiments described hereinafter.
In the drawings:

> Fig. 1 depicts a communication system according to an embodiment of the invention;
> Fig. 2 illustrates an LDPC code graph according to an embodiment of the invention;
> Fig. 3 shows a block diagram of an SNDR estimator according to an embodiment of the invention;
> Fig. 4 shows a block diagram of an SNDR estimator with a flooding schedule LDPC decoder according to an embodiment of the invention;
> Fig. 5 shows a block diagram of an SNDR estimator with a shuffled-schedule LDPC decoder according to an embodiment of the invention;
> Figs. 6a-d illustrate SNDR performance in an AWGN channel according to an embodiment of the invention;
> Fig. 7 shows a logic flow for an iteration-stopping criterion according to an embodiment of the invention;
> Fig. 8 depicts a block diagram of a link margin estimator according to an embodiment of the invention;

and

Figs. 9a-b illustrates the performance of a link margin estimator in an AWGN channel comprising distortions according to an embodiment of the invention.

DETAILED DESCRIPTION OF EMBODIMENTS

In the following detailed description of the preferred embodiments, reference is made to the accompanying drawings, which form a part hereof, and within which are shown by way of illustration specific embodiments by which the invention may be practiced. The drawings described are only schematic and are non-limiting. In the drawings, the size of some of the elements may be exaggerated and not drawn on scale for illustrative purposes. Those skilled in the art will recognize that other embodiments may be utilized and structural changes may be made without departing from the scope of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The signal quality estimator techniques that will be described in the following are applicable in various communication systems. They can be preferably applied in satellite communications, terrestrial wireless transmission, and transmission over electric cables or optical fibres. The inventive idea is most preferably adapted for satellite transmissions.

All techniques are preferably applicable to the following transmission systems: burst or continuous stream transmission; single carrier (SC) or multi-carrier (MC) transmission, orthogonal frequency division multiplexing (OFDM); code division multiple access (CDMA), time division multiple access (TDMA), frequency division multiple access (FDMA), OFDM access; point-to-point transmission, point to multipoint, broadcast, star or mesh network topologies; single or multiple antenna transmission and reception, preferably single-input single-output, multiple-input multiple output, single-input multiple-output and multiple-input single-output schemes.

All techniques are also applicable to linear and non-linear modulation types, and preferably to binary phase shift keying (BPSK), quadrature phase shift keying (QPSK), quadrature amplitude modulation (QAM), amplitude and phase shift keying (APSK), continuous phase modulation (CPM).

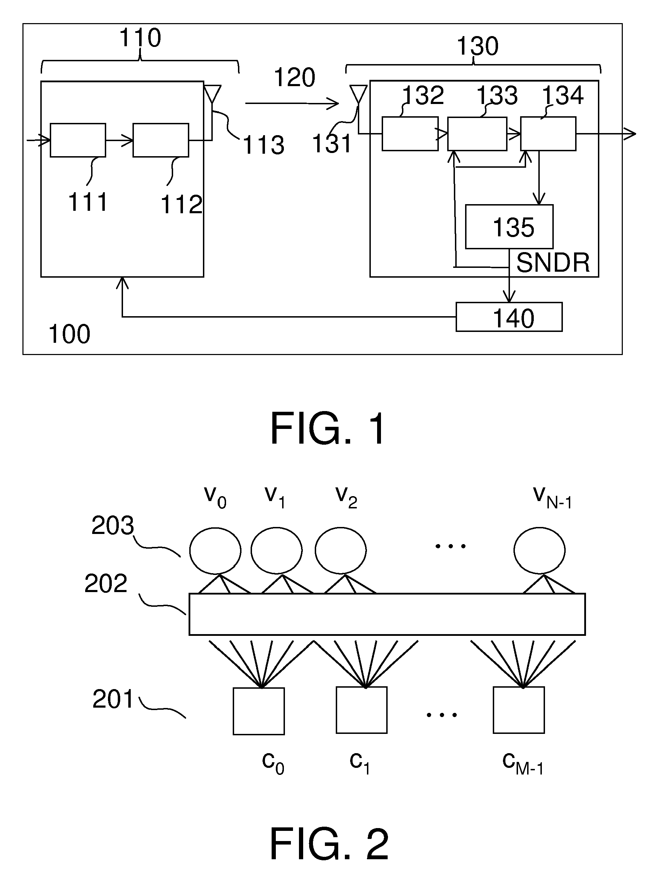

Fig. 1 shows an embodiment of the invention. A communication system (100) using a transmitter (110), a propagation channel (120) and a receiver (130). The transmitter comprises an FEC encoder (111), a modulator (112) and a first antenna (113). A single antenna is shown in this embodiment. The propagation channel (120) is a wireless or wired transmission medium. In other embodiments it further comprises several transmission links. In a satellite communication system, the propagation channel encompasses an earth-to-satellite link and a satellite-to-earth link. The receiver (130) comprises a second antenna (131), a demodulator (132), a symbol-to-bit log-likelihood ratio (LLR) module (133), a FEC decoder (134) and an SNDR estimator (135). The SNDR module computes an SNDR estimate based on information coming from the FEC decoder. The estimate is used by an automatic adaptive coding and modulation (ACM) link control module (140) that adapts the link parameters, such as the code rate and modulation order, to the channel propagation conditions, such as the BER. The SNDR estimate is used in the receiver to optimize the signal processing algorithm. It is also used by the symbol-to-bit LLR module (133) and the FEC decoder module (134). In this embodiment, the FEC code is an LDPC code, as explained in more detail in R.G. Gallager, "Low-Density Parity-Check Codes", 1963, MIT.

Fig. 2 shows a representation of an LDPC code according to an embodiment of the invention. A set of N variable nodes $v_0, ..., V_{N-1}$ (203) is connected to a set of M check nodes $c_0, ..., c_{M-1}$, (201) through a connection graph (202). The code is defined using its parity check matrix H, of size M lines and N columns, such as $H.C^T = 0$ for all code words $C=(v_0, v_1, ...v_{N-1})$. The ensemble N(m) of variables $v_n$ connected to check $c_m$ is denoted as $N(m) = \{n: H(m, n) \neq 0\}$ and the ensemble M(n) of checks $c_m$ connected to variable $v_n$ is denoted as $M(n)= \{m:H(m,n)\neq 0\}$. LDPC codes are very powerful codes and used in various transmission systems. An LDPC code is decoded using an iterative algorithm based on the belief propagation algorithm, described in Mackay, D.J.C., "Good Error-Correcting Codes Based on Very Sparse Matrices", in IEEE Transactions on Information Theory, March 1999. In other embodiments, the derivations of an iterative algorithm, as described in Chen, J. and Fossorier, M.P.C., "Decoding Low-Density Parity-Check Codes with Normalized APP-Based Algorithm", Proceedings of the Global Telecommunications Conference, GLOBECOM 2001, are used. An iterative decoding is based on the exchange of probabilistic information (messages) between variable nodes and check nodes along the edges of the code graph.

The historical scheduling applied to this iterative decoding is the so-called flooding schedule. Its execution will be described in the following: initialize the variable-to-check messages with channel observations (initialization); for each decoding iteration i (i=1 to I): first step (horizontal): for each check node $c_m$, m=0 to M-1, compute check-to-variable messages from variable-to-check messages using a check node algorithm known to the skilled person; second step (vertical): for each variable node $v_n$, n=0 to N-1, compute variable-to-check messages from check-to-variable messages and compute the bit posterior probability (or LLR) in order to perform hard decision, using a variable node algorithm known to the skilled person. Let $d_n^{(i)}$ be the hard decision for variable $c_n$ at iteration i; syndrome computation: compute the syndrome S(i) = H·D(i), where D(i) = $(d_0(i), d_1(i), ..., d_{N-1}(i))$; stop decoding if S=0, else continue decoding.

Alternative schedulings have been proposed and are referred to as "shuffled" schedulings. In Zhang, 1. and Fossorier, M.P.C. "Shuffled belief propagation decoding", Conference Record of the Thirty-Sixth Asilomar Conference on Signals, Systems and Computer, 2002, the following scheduling has been introduced: for each decoding iteration i (i=1 to I) {for each variable node $v_n$ (n=0 to N-1) {sub-step 1: compute the check-to-variable messages arriving to $v_n$, sub-step 2: compute the variable-to-check messages departing from $v_n$; sub-step 3: compute the bit posterior LLR and hard decision $d_n^{(i)}$}; syndrome computation: compute the syndrome $S^{(i)}$ = H·$D^{(i)}$, where $D^{(i)}$ = $(d_0^{(i)}, d_1^{(i)}, ..., d_{N-1}^{(i)})$; stop decoding if S=0, else continue decoding }.

In Boutillon E., Tousch J. and Guilloud F., "LDPC decoder, corresponding method, system and computer program", US Patent Issued on February 6, 2007, the so-called "horizontal" schedule is used: for each decoding iteration i (i=1 to I) {for each check node $c_m$ (n=0 to M-1) {sub-step 1: compute first the variable-to-check messages arriving to $c_m$, sub-step 2: compute the check-to-variable messages departing from $c_m$; sub-step 3: compute the bit posterior LLR and hard decision $d_n^{(i)}$}}; syndrome computation: compute S(i) = H·D(i), where $D^{(i)}$ = $(d_0^{(i)}, d_1^{(i)}, ..., d_{N-1}^{(i)})$; stop decoding if S=0, else continue decoding}. In this embodiment of the invention an SNDR estimator based on syndrome computation is performed in an LDPC decoder.

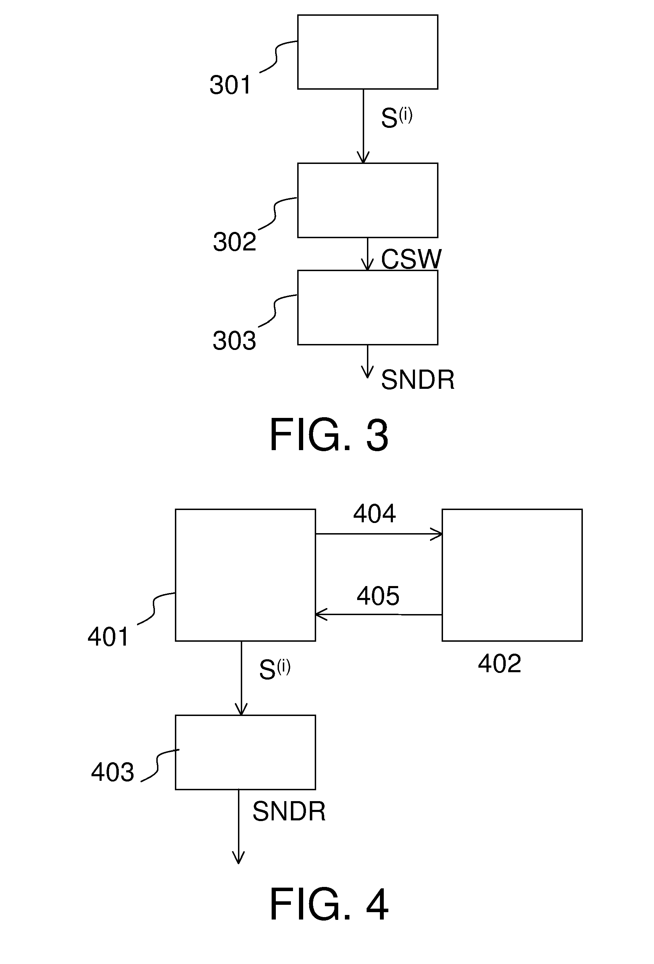

Fig. 3 illustrates a block diagram of an SNDR estimator according to another embodiment of the invention. The LDPC decoder (301) performs LDPC decoding iterations. At each iteration i, the syndrome $S^{(i)}$ is outputted and used by a Hamming weight accumulator (302), which performs the Hamming weight computation of $S^{(i)}$ and its summation over all decoding iterations. Let denote w(x) the Hamming weight of a vector x having values in the Galois field GF(2). The Hamming weight accumulator performs the computation of the so-called cumulative syndrome weight (CSW) according to the following equation:

$$CSW = \sum_{i=0}^{I} w(S^{(i)}).$$

The SNDR estimate is read from a table look-up (303) addressed by the CSW value according to the following relation:

$$SNDR = LUT(CSW).$$

Fig. 4 shows the estimator within a flooding scheduled LDPC decoder according to another embodiment of the invention. A variable node processor (401), which may contain several variable node processing units working concurrently on several variables, is used to perform the decoding vertical step. A check node processor (402), which may contain several check node processing units working concurrently on several checks, is used to perform the decoding horizontal step. Variable and check node processors produce and exchange variable-to-check (404) and check-to-variable messages (405), as has been described above. The variable node processor (401) computes the syndrome $S^{(i)}$ after each iteration i. The SNDR estimator (403) uses $S^{(i)}$ as described in Fig 3.

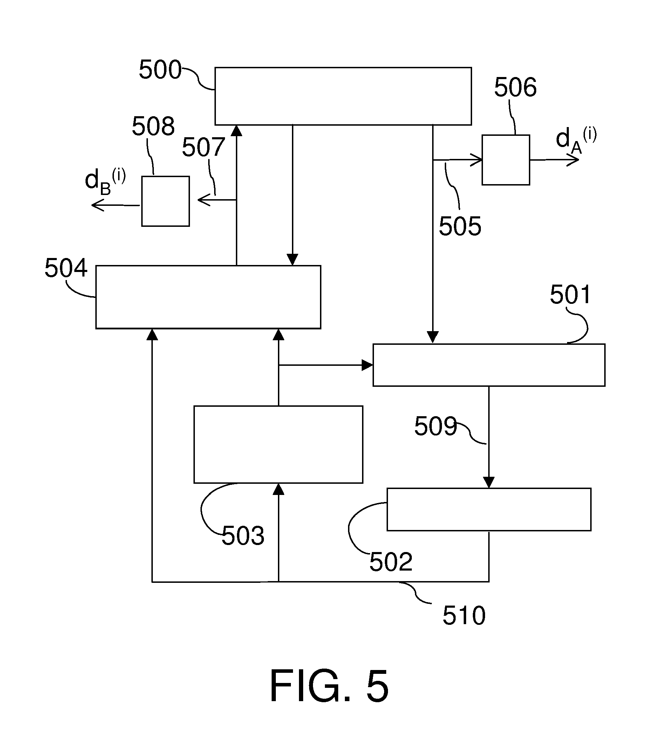

Fig 5 illustrates the use of an estimator in a horizontal shuffled LDPC decoding schedule according to yet another embodiment of the invention. Such an LDPC decoder comprises: a first storage unit (or memory) (500) for storing the posterior probabilities or LLR on bits which will be called posterior bit-LLRs in the following; a variable node processor (501) performing the computation of variable-to-check messages (509) (sub-step 1); a check node processor (502) performing the computation of check-to-variable messages (510) (sub-step 2); a module (504) used to perform the posterior bit-LLR computation (sub-step 3); a second storage unit (503) adapted for storing the check-to-variable messages (510) from one iteration to the next iteration. A syndrome $S_A^{(i)}$ can be computed from the posterior bit-LLRs values read from memory (500) to feed the variable node processor (501). This is illustrated by the connection (505) in Fig. 5 with the hard decision module (506). For each check m, the m-th element of the vector $S_A^{(i)}$ is then computed using the relation:

$$S_A^{(i)}(m) = \sum_{n \in N(m)} d_A^{(i)}(n).$$

$S_A^{(i)}$ is used by the SNDR estimator as has been described above. Alternatively, in yet another embodiment, instead of using the syndrome $S_A^{(i)}$, another syndrome denoted $S_B^{(i)}$ can be obtained from the posterior bit-LLRs written into the memory (500) at the output of the substep 3 module (504). This is illustrated by the connection (507) in Fig. 5 and the hard decision module (508), yielding $d_B^{(i)}$ values. For each check m, the m-th element of the vector $S_B^{(i)}$ is then computed using the following formula:

$$S_B^{(i)}(m) = \sum_{n \in N(m)} d_B^{(i)}(n).$$

$S_B^{(i)}$ is used by an SNDR estimator as has been described above. In this embodiment the performance illustrations are obtained with a horizontal-shuffled schedule LDPC decoder, using a maximum of twenty iterations, and syndrome type $S_A$. Similar results are obtainable with a flooding-scheduled decoder or by using $S_B^{(i)}$ in a shuffled-scheduled decoder.

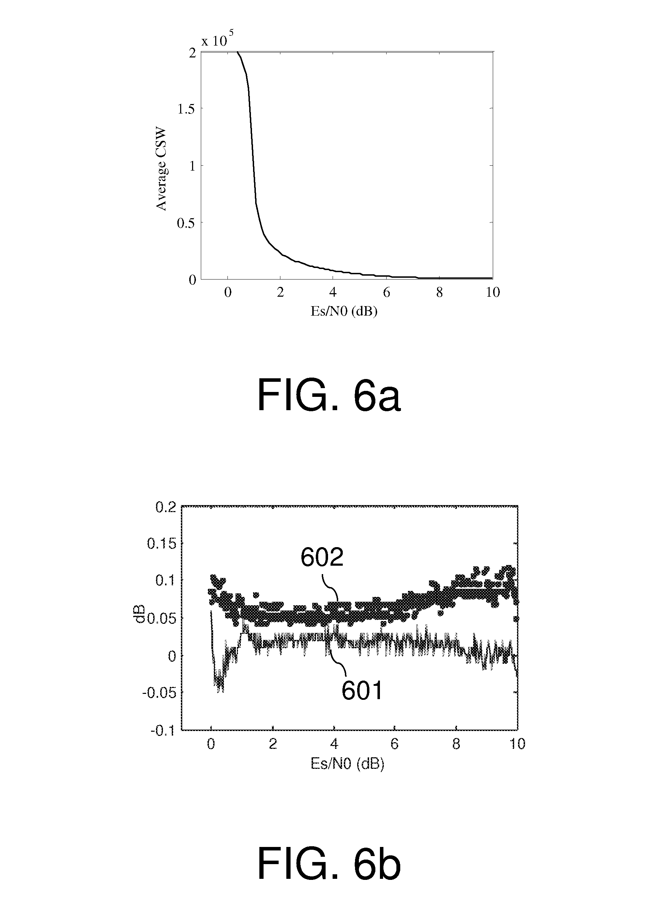

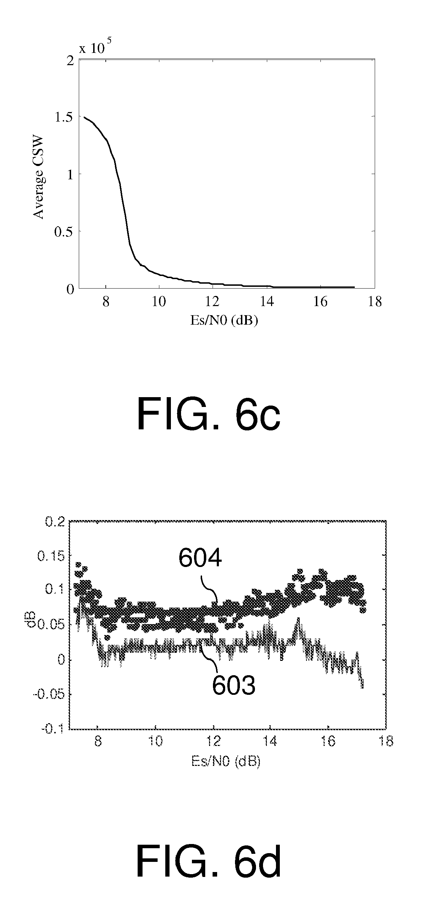

Figs. 6 a to d illustrate the performance of an SNDR estimator in the context of DVB-S2, as has been described above. The frame size comprises 64800 coded bits. Two different modulation and coding rates are considered: QPSK ½ (see Figs. 6a and 6b) and 16APSK 2/3 (see Figs. 6c and 6d). The channel corresponds to an AWGN channel with no distortions. In this embodiment the SNDR estimate is equal to an SNR estimate. It goes without saying that all signal-to-noise ratios are expressed in the well-known logarithm format (in dB): $x = 10 \cdot \log 10(x_1)$ in dB, where $x_1$ is the linear expression of x.

Fig. 6a shows the average CSW value obtained over a Monte-Carlo simulation for different SNR values (Es/NO values). The calibration step of the look-up table (LUT) used in the estimator is going to be described in the following. y=f(x) is called the underlying function giving the average CSW value as a function of $Es/N_0$:

$$E\{CSW\}_{cal} = f\left(\frac{E_s}{N_0}\right),$$

where $E\{X\}_{cal}$ is the average value of X over the calibration process. The SNDR estimate is finally obtained with the following look-up function:

$$SNDR = f^{-1}_{sampled}(CSW),$$

where $f^{-1}_{sampled}$ is a sampled version of the inverse function $x = f^{-1}(y)$. Since the function f is monotonic, the inverse function exists. The number of entries in the look-up function is a receiver design parameter that depends on the desired estimator accuracy. In the performance illustrations of Figs. 6 a to d, the number of entries is 100 and corresponds to an $Es/N_0$ range of 10 dB with steps of 0.1 dB. Fig. 6b shows the bias (601) and standard deviation (602) of the SNDR estimator over a Monte-Carlo simulation for an $Es/N_0$ range between 0 and 10 with steps of 0.02 dB. The estimator uses the LUT calibrated by the numerical values given in Fig. 6a. The estimator bias is within 0.05 dB and the standard deviation is below 0.12 dB over the predefined Es/N0 range.

Fig. 6c and Fig. 6d give the estimator results for 16APSK 2/3 in the $Es/N_0$ range between 7 and 17 dB. The estimator bias (603) is within 0.1 dB and the standard deviation (604) is below 0.15 dB over the predefined Es/N0 range. The above performance is obtained with an estimator working preferably on a single code block and, therefore, reaching reasonable latency properties. For shorter blocks an averaging over several consecutive blocks of the CSW computation or the SNDR estimate can be applied. This is preferably applied in order to reach the desired accuracy level.

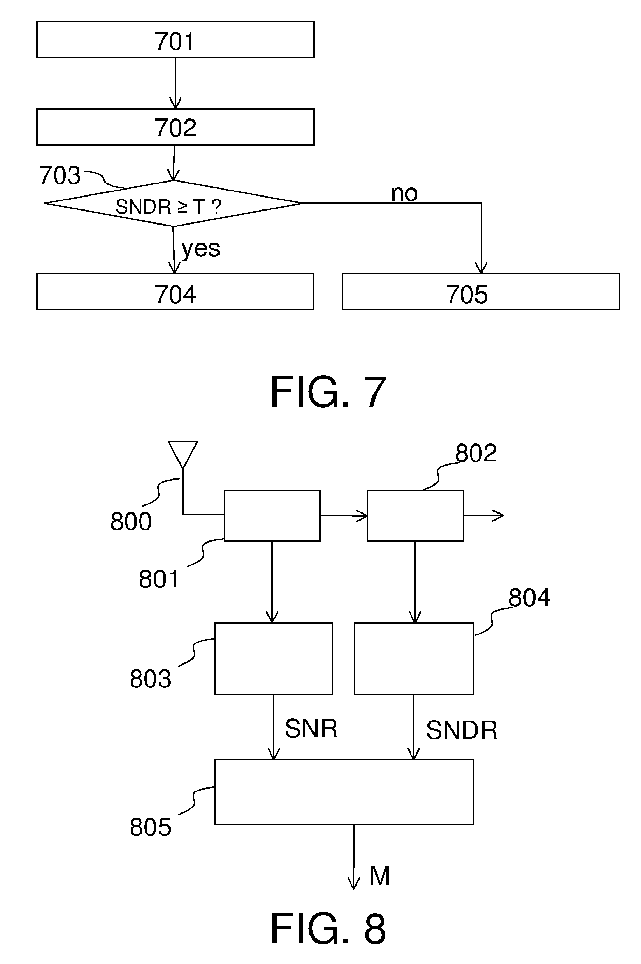

In the area of iterative decoding, it is of importance to be able to know, for each transmitted block of data, whether the decoder has a reasonable chance to correct the transmission errors or not. This knowledge can be used to discard the corresponding blocks prior or during decoding and save significant computational load which translates immediately into power savings, and can also be translated in increased performance if the saved computational load is used for other blocks. A decision criterion for determining whether there is a reasonable chance to successfully decode a block is going to be described in the following. The decision criterion is based on the SNDR estimate described above. The logic flow of the decision criterion according to yet another embodiment of the invention is presented in Fig. 7. The LDPC decoder performs J decoding iterations (701), with J < I (I is the maximum number of iterations). An SNDR estimation is carried out (702) based on the CSW value computed over these J iterations. The SNDR estimate is compared to a threshold value T (703). If SNDR $\geq$ T, the decoding process continues normally (704). If SNDR < T, the decoder stops (705) and an indication of erroneous decoding is reported. The number of iterations J is a design parameter reflecting the trade-off between the accuracy of the criterion and the amount of computational load savings. For high values of J, the criterion is more reliable but the savings are reduced. The threshold value T is a pre-determined design parameter which depends on the number of iterations J and reflects the desired trade-off between false alarm events (frames having been stopped, for which a complete decoding would have led to a successful decoding) and non-detection events (frames not being stopped, containing residual errors after complete decoding).

A link margin estimator according to another embodiment of the invention is illustrated in Fig. 8. The link margin estimator is built as a combination of an SNDR estimator and an SNR estimator. The aim of the link margin estimate is to give an estimate of the distance (in dB) between the actual $Es/N_0$ observed at the receiver and the minimum $Es/N_0$ possible for reliable transmission. Reliable transmission is defined using a given level of Quality of Service (QoS) or packet error rate (PER). For instance in an DVB-S2 system, a typical QoS used is the so-called "Quasi-Error-Free" (QEF) condition given by a PER of $10^{-7}$. A good link margin estimate M is then expected to be of the form:

$$M = \frac{E_s}{N_0} - \left(\frac{E_s}{N_0}\right)_{MIN},$$

where $(Es/N_0)_{MIN}$ is the minimum $Es/N_0$ value ensuring the desired QoS.

In an AWGN channel, a link margin can simply be derived from an estimate of the received $Es/N_0$ (SNR estimator). $(Es/N_0)_{THR}$ is denoted as the value of $(Es/N_0)_{MIN}$ in an AWGN channel. $(Es/N_0)_{THR}$ is constant and known from off-line system simulations or measurements. A simple link margin estimate $M_{SNDR}$ (also indicated as M in Fig. 8) can thus be obtained with the SNDR estimator presented earlier with:

$$M_{SNDR} = SNDR - \left(\frac{E_s}{N_0}\right)_{THR}.$$

In a channel comprising distortions, $(Es/N_0)_{MIN}$ depends on the distortion level and is not known by the receiver. In this embodiment a link margin estimator is built by combining an SNDR estimator with an SNR estimator.

Fig 8 shows a block diagram of the link margin estimator as has been already described. The transmission signal is received at an antenna (800) and directed to a demodulator (801). Afterwards, the signal is split to an FEC decoder (802) and to an SNR estimator (803). The link margin estimator value $M_h$ is given by:

$$M_h = SNR - Q,$$

where the SNR is computed by (803) using a predetermined algorithm, in this embodiment it is the DA-SNORE algorithm, and Q is an estimate of $(Es/N_0)_{MIN}$, built as follows (in the following, a subscript 1 is used to designate a linear version of a log-domain quantity : x = 10*log10 $(x_1)$):

$$Q_l = \cfrac{1}{\cfrac{1}{\left(\dfrac{E_S}{N_0}\right)_{THR,l}} - \cfrac{1}{SDR_l}},$$

where $(Es/N_0)_{THR}$ is the $(Es/N_0)_{QoS}$ value of the channel in AWGN conditions, as introduced above. $(Es/N_0)_{THR}$ is constant and known by the receiver. SDR is the signal-to-distortion ratio that is obtained as follows:

$$SDR_l = \cfrac{1}{\cfrac{1}{SNDR_l} - \cfrac{1}{SNR_l}},$$

where SNDR represents the SNDR estimate, as provided by the SNDR estimator (804) described above. Finally, the link margin is computed (805).

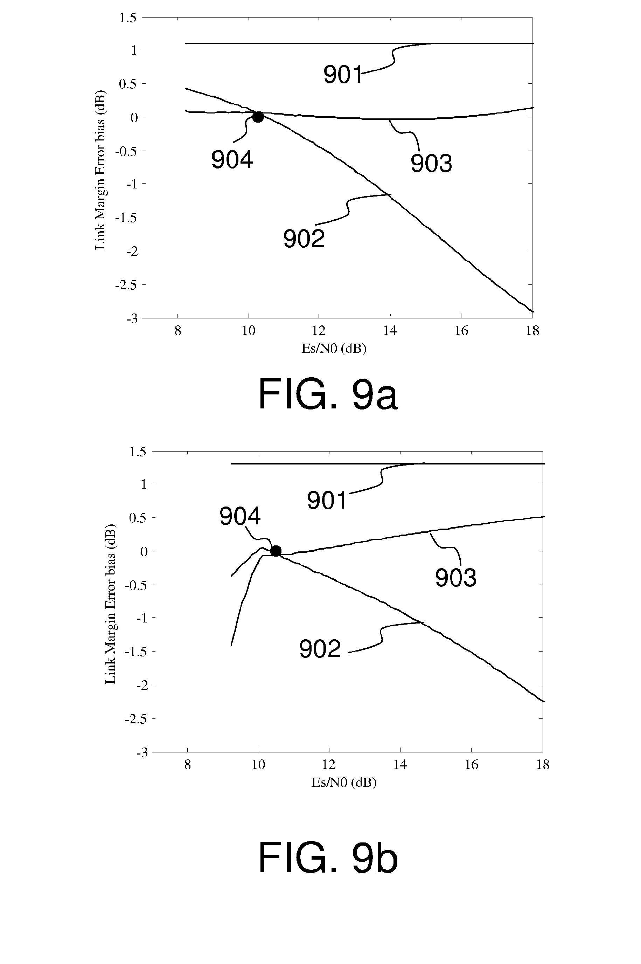

Fig. 9a and Fig. 9b illustrate the performance of the link margin estimator according to the previous embodiment. The link margin estimator is used in the context of DVB-S2 with 64800 bits frames, 16APSK modulation, and a code rate of 2/3. The QoS assumed is the QEF performance as has been defined above. Three distinct link margin estimators are presented: First, "SNR only" (901) is a link margin estimator based on merely an SNR estimator. The link margin is computed using the relation:

$$M_{SNR} = SNR - \left(\frac{E_s}{N_0}\right)_{THR}.$$

Second, "SNDR only" (902) is a link margin estimator based on an SNDR estimator, as has been described above ($M_{SNDR}$). Third, "combined SNR and SNDR" (903) is a link margin estimator based on SNR and SNDR estimators, as also has been described above ($M_h$). In all the results presented, the SNR estimation is assumed to be ideal (i.e. SNR = Es/N0). In a real system, the performances of the combined estimator would also be influenced by the accuracy of the SNR estimation.

Fig. 9a shows the bias of the different link margin estimators in a channel containing a residual static phase error, i.e. the baseband complex samples are affected by an eight degrees phase rotation with respect to ideal values, prior to symbol-to-bit demapping and decoding. The (unknown) $(Es/N0)_{MIN}$ amounts 10.3 dB. The known $(Es/N0)_{THR}$ amounts 9.2 dB. $M_{SNR}$ shows a constant bias equal to 1.1 dB (see curve (901) in Fig. 9a). $M_{SNDR}$ has almost no bias at the QoS point (10.2 dB) and suffers from an increased bias when $Es/N_0$ increases. For $Es/N_0$ below 13.5 dB, $M_{SNDR}$ is however better than the $M_{SNR}$ (see curve (902) in Fig. 9a). Note also that the zero-bias at QEF point (904 in Fig. 9a) is an interesting behaviour for an ACM system, where it may be sufficient to know whether the link comprises a margin or if it does not. The combined estimate $M_h$ (903) shows a significantly better behaviour than the two other estimators, with a bias below 0.1 dB over the predefined $Es/N_0$ range. The standard deviation of all three estimators is below 0.1 dB.

Fig. 9b shows the bias of the different link margin estimators in a channel containing an amplitude estimation error at the input of the symbol-to-bit demapper. An error of 1.5 is assumed in this embodiment, meaning that the complex baseband symbols are 1.5 times larger in amplitude than the ideal symbols delivered by a perfect demodulator. The (unknown) $(Es/N0)_{MIN}$ amounts 10.5 dB. The known $(Es/N0)_{THR}$ amounts 9.2 dB. The conclusions are similar to embodiment of Fig. 9a: The combined estimator (see curve (903) in Fig. 9b) shows almost zero bias at QEF point (see (904) in Fig. 9b) and limited bias up to $Es/N_0$=18 dB (maximum 0.5 dB bias). The combined estimator shows a significantly better performance than the two other estimators (see curves (901) and (902) in Fig. 9b).

Finally, it is worth noting that an estimated link margin drives the state machine that selects the transmission mode in a communication system. The feedback channel from a receiver to a transmitter can be realized via any communication link.

The present invention also provides a decoder unit for use with an error correction code. The decoder unit may be implemented in hardware or in software. For example the decoder unit may include a processing engine having a Central Processing Unit ("CPU"), such as an embedded processor or a conventional microprocessor of which a Pentium processor supplied by Intel Corp. USA is only an example, and a number of other units interconnected via bus system. The bus system may be any suitable bus system. The processing engine includes at least one memory. Memory may include any of a variety of data storage devices known to the skilled person such as random-access memory ("RAM"), read-only memory ("ROM"), non-volatile read/write memory such as a solid state memory or a hard disc as known to the skilled person. For example, processing engine may further include random-access memory ("RAM"), read-only memory ("ROM"), and an optional input/output (I/O) adapter for connecting peripheral devices to the system bus.

In addition, the processing engine can include a control program that resides within memory storage. The control program contains instructions that when executed on the CPU allow the computer to carry out the operations described with respect to any of the methods of the present invention.

The decoder unit may comprise:

a) means for evaluating a code syndrome vector for a plurality of decision bits in an error correction decoder;
b) means for computing the Hamming weight of the code syndrome vector; and
c) means for estimating the quality of the error correction decoder input signal based on the computed Hamming weight.

The means for estimating is preferably adapted to use the sum of the plurality of Hamming weights provided by the means for computing for the plurality of code syndrome vectors.

The error correction decoder preferably uses an error correction code comprising a low density parity check code.

Optionally the error correction decoder is adapted for performing an iterative process, the iterative process corresponding to one of a flooding-scheduled sum-product algorithm and a shuffled-scheduled sum-product algorithm. The means for estimating signal quality may be adapted for stopping the iterative process after a predetermined number of iterations. The predetermined number of iterations can be fixed by comparing the computed Hamming weight of a code syndrome vector with a predetermined value and/or by evaluating an SNDR estimate.

The decoder unit may also comprise:

d) means for computing the signal-to-noise ratio; and
e) means for combining the computed signal-to-noise ratio with an error correction decoder input signal quality estimation from the means for estimating the quality of the error correction decoder input signal.

Also the means for estimating the quality of the error correction decoder input signal can be adapted to translate the estimated quality into an estimation of a transmission link noise margin. Also the means for estimating the quality of the error correction decoder input signal can be adapted to adapt the transmission link noise margin estimation for an adaptive coding and modulation system for optimizing transmission parameters with regard to propagation conditions of the transmission system.

Whereby, the transmission parameters can comprise code rate and modulation order and the propagation conditions can comprise the bit error rate.

The present invention also provides a computer program product for carrying out the method of the present invention and this can reside in any suitable memory. However, it is important that while the present invention has been, and will continue to be, that those skilled in the art will appreciate that the mechanisms of the present invention are capable of being distributed as a computer program product in a variety of forms, and that the present invention applies equally regardless of the particular type of signal bearing media used to actually carry out the distribution. Examples of computer readable signal bearing media include: recordable type media such as floppy disks and CD ROMs and transmission type media such as digital and analogue communication links.

Accordingly, the present invention also includes a software or computer program product comprising code segments that when executed on a suitable processing engine implement a method adapted for a transmission system for use with an error correction code, the code segments implementing when executed:

a) evaluation of a code syndrome vector for a plurality of decision bits in an error correction decoder;
b) computing of the Hamming weight of the code syndrome vector; and
c) estimating of the quality of the error correction decoder input signal based on the computed Hamming weight.

The code segments implementing the error correction decoder are adapted for performing an iterative process corresponding to performing step b) for a plurality of code syndrome vectors each being evaluated in step a).

The code segments are further adapted to perform step c) by using the sum of the plurality of Hamming weights computed in step b) for the plurality of code syndrome vectors.

For use with the software product, the error correction code may comprise a low density parity check code.

The code segments are adapted, when executed, to implement the iterative process corresponding to one of a flooding-scheduled sum-product algorithm and a shuffled-scheduled sum-product algorithm.

The code segments, when executed are also adapted such that the signal quality estimation in step c) is adapted for stopping the iterative process after a predetermined number of iterations. The predetermined number of iterations can be fixed by comparing the computed Hamming weight of a code syndrome vector with a predetermined value and/or by evaluating an SNDR estimate.

The code segments may also be adapted, when executed, to:

d) compute the signal-to-noise ratio; and
e) combine the computed signal-to-noise ratio with the error correction decoder input signal quality estimation of step c).

They may further translate the error correction decoder input signal quality estimation into an estimation of a transmission link noise margin. The transmission link noise margin estimation may be adapted for an adaptive coding and modulation system for optimizing transmission parameters with regard to propagation conditions of the transmission system, whereby the transmission parameters may comprise code rate and modulation order and the propagation conditions comprise the bit error rate.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practising the claimed invention, from a study of the drawings, the disclosure, and the appended claims. In the claims, the indefinite article "a" or "an" does not exclude a plurality. The mere fact that certain measures are recited in mutually different dependent claims does not indicate that a combination of these measures cannot be used to advantage.

A single unit may fulfil the functions of several items recited in the claims. Any reference signs in the claims should not be construed as limiting the scope.

**Claims**

1. A method, adapted for a transmission system adapted to use an error correction code, comprising the steps:

a) evaluating a code syndrome vector for a plurality of decision bits in an error correction decoder;
b) computing the Hamming weight of the code syndrome vector; and
c) estimating the quality of the error correction decoder input signal based on the computed Hamming weight.

2. The method according to claim 1, wherein the error correction decoder is adapted for performing an iterative process corresponding to performing step b) for a plurality of code syndrome vectors each being evaluated in step a).

3. The method according to claim 2, further performing step c) by using the sum of the plurality of Hamming weights computed in step b) for the plurality of code syndrome vectors.

4. The method according to any of claims 2 and 3, wherein the error correction code comprises a low density parity check code.

5. The method according to claim 4, wherein the iterative process corresponds to one of a flooding-scheduled sum-product algorithm and a shuffled-scheduled sum-product algorithm.

6. The method according to any of the claims to 5, wherein the signal quality estimation in step c) is adapted for stopping the iterative process after a predetermined number of iterations.

7. The method according to claim 6, wherein the predetermined number of iterations is fixed by comparing the computed Hamming weight of a code syndrome vector with a predetermined value and/or by evaluating an SNDR estimate.

8. The method according to any of claims 1 to 7, further comprising the steps:

    d) computing the signal-to-noise ratio; and
    e) combining the computed signal-to-noise ratio with the error correction decoder input signal quality estimation of step c).

9. The method according to any of claims 1 and 8, wherein the error correction decoder input signal quality estimation is translated into an estimation of a transmission link noise margin.

10. The method according to claim 9, wherein the transmission link noise margin estimation is adapted for an adaptive coding and modulation system for optimizing transmission parameters with regard to propagation conditions of the transmission system.

11. The method according to claim 10, wherein the transmission parameters comprise code rate and modulation order and the propagation conditions comprise the bit error rate.

12. A transmission system for use with an error correction code, comprising:

    a) means for evaluating a code syndrome vector for a plurality of decision bits in an error correction decoder;
    b) means for computing the Hamming weight of the code syndrome vector; and
    c) means for estimating the quality of the error correction decoder input signal based on the computed Hamming weight.

13. A decoder unit for use with an error correction code, comprising:

    a) means for evaluating a code syndrome vector for a plurality of decision bits in an error correction decoder;
    b) means for computing the Hamming weight of the code syndrome vector; and
    c) means for estimating the quality of the error correction decoder input signal based on the computed Hamming weight.

14. A computer program product comprising code segments that when executed on a suitable processing engine implement a method adapted for a transmission system for use with an error correction code, the code segments implementing when executed:

    a) evaluation of a code syndrome vector for a plurality of decision bits in an error correction decoder;
    b) computing of the Hamming weight of the code syndrome vector; and
    c) estimating of the quality of the error correction decoder input signal based on the computed Hamming weight.

15. A machine readable signal storage medium storing the computer program product of claim 14.

# FIG. 1

# FIG. 2

301 → [ ]

$S^{(i)}$

302 → [ ]

CSW

303 → [ ]

SNDR

# FIG. 3

401 → [ ]

404 →

405 ←

402

$S^{(i)}$

403 → [ ]

SNDR

# FIG. 4

FIG. 5

FIG. 6a

FIG. 6b

## FIG. 6c

## FIG. 6d

701

702

703 ⟨ SNDR ≥ T ? ⟩ → no

yes

704                    705

# FIG. 7

800
801
802
803
804
805

SNR        SNDR

M

# FIG. 8

FIG. 9a

FIG. 9b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. Pauluzzi ; N. Beaulieu.** A comparison of SNR Estimation Techniques for the AWGN Channel. *IEEE Transactions on Communications,* October 2000
- Channel Quality Estimation techniques for adaptive physical layer satellite systems. *ESA contribution to Digital Video Broadcasting,* March 2003
- **M.C. Reed ; J. Asenstorfer.** A novel variance estimator for turbo-code decoding. *Proc. Int. Conf. Telecommun.,* April 1997
- **R.G. Gallager.** Low-Density Parity-Check Codes. *MIT,* 1963

- **Mackay, D.J.C.** Good Error-Correcting Codes Based on Very Sparse Matrices. *IEEE Transactions on Information Theory,* March 1999
- **Chen, J. ; Fossorier, M.P.C.** Decoding Low-Density Parity-Check Codes with Normalized APP-Based Algorithm. *Proceedings of the Global Telecommunications Conference, GLOBECOM,* 2001
- **Zhang, 1. ; Fossorier, M.P.C.** Shuffled belief propagation decoding. *Conference Record of the Thirty-Sixth Asilomar Conference on Signals, Systems and Computer,* 2002
- **Boutillon E. ; Tousch J. ; Guilloud F.** *LDPC decoder, corresponding method, system and computer program*